# EUROPÄISCHE PATENTSCHRIFT

(11) **EP 0 529 748 B1**
(45) Veröffentlichungstag und Bekanntmachung des Hinweises auf die Patenterteilung: **04.01.1995**
(21) Anmeldenummer: 92250194.5
(22) Anmeldetag: 21.07.1992
(51) Int. Cl.: H05K 9/00

(54) **Schaltschrank zur wahlweisen Aufnahme elektrischer und/oder elektronischer Geräte und Baugruppen**
Switch cabinet for selectively housing electric or electronic devices and assemblages
Armoire de commande pour caser des appareils et/ou des ensembles électriques ou électriques

(30) Priorität: 23.08.1991 DE 4128398
(43) Veröffentlichungstag der Anmeldung: 03.03.1993
(73) Patentinhaber: SIEMENS AKTIENGESELLSCHAFT, 80333 München (DE)
(72) Erfinder: Blum, Richard, W-6057 Dietzenbach (DE); Herr, Klaus-Jürgen, W-6467 Hasselroth 1 (DE); Groh, Hans-Michael, W-6452 Hainburg 2 (DE); Kürster, Willi, W-6460 Gelnhausen (DE)

(56) Entgegenhaltungen:
- EP-A- 0 404 284
- EP-A- 0 428 335
- DE-A- 2 601 277
- DE-A- 3 204 274
- DE-A- 3 209 349
- DE-B- 2 451 192

## Beschreibung

Die Erfindung betrifft einen Schaltschrank zur wahlweisen Aufnahme elektrischer und/oder elektronischer Geräte und Baugruppen mit folgenden Merkmalen:
- ein Gerüst aus Profilschienen mit mehrfach abgewinkelter Querschnittsform;
- wenigstens eine Tür und Abdeckungen zur Verkleidung des Gerüstes und zum Schutz der Geräte und/oder Baugruppen gegen Einflüsse der Umgebung einschließlich der elektromagnetischen Wellen in einem die Funktion der Geräte und/oder Baugruppen betreffenden Frequenzbereich;
- die Profilschienen besitzen an ihrer für das Zusammenwirken mit einer Abdeckung vorgesehenen Seite eine Einziehung sowie drei gegeneinander versetzte Teilflächen, von denen die eine Teilfläche durch die Einziehung von den weiteren beiden Teilflfächen getrennt ist;
- die Abdeckung besitzt an ihrem Rand eine Abwinklung zum Eingreifen in die Einziehung der Profilschiene;
- die Abdeckung überdeckt die weiteren beiden an die Einziehung angrenzenden Teilflächen der Profilschiene.

Ein Schaltschrank mit diesen Merkmalen ist z. B. durch die EP-A-0 404 284 bekanntgeworden. Aufgrund der allgemeinen Eignung eines solchen Schaltschrankes zur Aufnahme beliebiger Geräte und Baugruppen wird dabei auch die Forderung gestellt, daß ein ausreichendes Maß von elektromagnetischer Verträglichkeit (EMV) gewährleistet ist, damit ohne aufwendige zusätzliche Maßnahmen auch empfindliche elektronische Geräte und Baugruppen zuverlässig arbeiten können. Da Schaltschränke aus Stahlblech, also einem elektrisch leitenden und weichmagnetischen Werkstoff hergestellt werden, könnte an sich angenommen werden, daß von außen einfallende Störungen wie Funkwellen, wetterbedingte Störfelder oder Einflüsse durch benachbarte starkstromtechnische Geräte und Anlagen ausreichend gedämpft werden und somit auch empfindliche elektronische Geräte unbeeinflußt arbeiten können. In der Praxis erweist es sich jedoch, daß diese Annahme nicht zutrifft. Vielmehr bedarf es zusätzlicher Maßnahmen, um das erforderliche störungsfreie Arbeiten elektronischer Bauteile sicherzustellen. Insbesondere hat es sich gezeigt, daß aus konstruktiven und fertigungstechnischen Gründen verbleibende oder bewußt vorgesehene Spalte zwischen dem Gerüst und den Abdeckungen eine Durchlässigkeit für elektromagnetische Strahlung besitzen, die den Betrieb elektronischer Baugruppen beeinträchtigen kann. Die normale Bauweise von Schaltschränken genügt daher nicht für ein ausreichendes Maß von EMV.

An sich ist es bekannt, an Gerüsten oder Gehäusen für elektronische Geräte vorhandene Spalte durch elastische Dichtungsstoffe in der Gestalt von Streifen oder Bändern zu verschließen, wobei diese Dichtungsstoffe neben ihrer Elastizität durch beigebene leitfähige und/oder magnetisch wirksame Stoffe zusätzlich die Eigenschaft haben, für elektromagnetische Wellen mehr oder weniger undurchlässige zu sein. Ein Beispiel für ein solches "EMV-Dichtungsmaterial" ist der EP-A-0 392 821 zu entnehmen.

Der Erfindung liegt die Aufgabe zugrunde, eine gesteigerte Dichtigkeit eines Schaltschrankes der eingangs genannten Art gegen elektromagnetische Strahlung trotz Beibehaltung von Spalten unter Vermeidung nachträglich anzubringender Hilfsmittel, wie elastische und elektromagnetische Wellen dämpfende Zwischenlagen oder Dichtungsstreifen, zu erzielen.

Die Erfindung löst die Aufgabe durch folgende Merkmale:
- die Abdeckung besitzt in einer Reihe angeordnete Einprägungen zur Auflage auf der von der Einziehung weiter entfernten Teilfläche der Profilschiene;
- die Höhe der Einprägungen ist zur Erlangung eines geringen, die Dicke des Materials der Abdeckung nicht übersteigenden Abstandes zwischen der Abdeckung und der an die Einziehung angrenzenden, von der Abdeckung überdeckten Teilfläche der Profilschiene bemessen, und
- die Einziehung besitzt eine Fußweite von etwa der doppelten Dicke des Materials der Profilschiene.

Der Schaltschrank nach der Erfindung besitzt daher im Bereich der Abdeckungen Spalte, die einen Luftaustausch zwischen dem Inneren des Schaltschrankes und seiner Umgebung ermöglichen. Dies ist vorteilhaft im Hinblick insbesondere auf die Erwärmung und die Bildung von Schwitzwasser im inneren des Schaltschrankes. Versuche haben dennoch erwiesen, daß die angegebene Anordnung und Bemessung im Bereich der Profilschienen und der auf ihnen aufliegenden Abdeckungen ein gutes Maß an Dämpfung störender elektromagnetische Strahlung ergibt. Da dieses Ergebnis auf konstruktiven Merkmalen beruht, d. h. auf einer während der Benutzungsdauer des Schaltschrankes unveränderlichen Gestaltung, wird ein Vorteil gegenüber der Verwendung von elastischen Dichtungen erzielt, die einer Alterung unterliegen, bei Wartungs- oder Reparaturarbeiten beschädigt oder aus Unkenntnis ihrer Bedeutung entfernt werden können.

Je nach einem bestimmten geforderten Maß von Dichtigkeit gegen elektromagnetische Strahlung können weitere Gestaltungsmerkmale und insbesondere spezielle Bemessungen vorgesehen sein.

In diesem Sinn hat es sich erwiesen, daß gute Ergebnisse erzielt werden, wenn der geringe Abstand zwischen der an die Einziehung angrenzenden Teilfläche und der Abdeckung etwa der halben Dicke des Materials der Abdeckung entspricht.

Ferner beeinflußt die Gestaltung der Einziehung das angestrebte Ergebnis. Vorteilhaft ist es, daß die Einziehung eine Tiefe von etwa dem zwei- bis dreifachen Wert der Fußweite hat und daß die Einziehung eine Mündungsweite besitzt, die zu der Fußweite im Verhältnis von etwa zwei zu eins steht. Als zusätzliche Maßnahme empfiehlt es sich dabei, daß das Ende der Abkantung der Abdeckung dem Boden der Einziehung in einem der Dicke des Materials der Abdeckung entsprechenden Abstand gegenübersteht.

Der die Einziehung und die Abkantung der Abdeckung umfassende Bereich des Schaltschrankes ist gegenüber einer auftretenden elektromagnetischen Strahlung vor allem durch mehrfache Reflektion bzw. Spiegelung wirksam. Diese Wirkungen können dadurch unterstützt bzw. ergänzt werden, daß die Abkantung als Kontaktleiste zur leitenden Verbindung der Abdeckung mit der Profilschiene ausgebildet ist. Eine solche Kontaktleiste kann durch ein gesondertes, mit der Abkantung zu verbindendes Bauteil oder durch eine spezielle Gestaltung der Abkantung selbst gebildet sein. Insbesondere kann der Endbereich der Abkantung mit Zähnen versehen sein. Die Zähne treten bei der Anbringung der Abdeckung an dem Gerüst des Schaltschrankes mit dem Material der Profilschienen in elektrische leitende Verbindung, indem sie eine dort befindliche Beschichtung oder Fremdschichten durchdringen. Eine hierfür erwünschte Andruckkraft kann dabei ohne besondere Maßnahmen durch die Federung der Abkantung zwischen ihren Befestigungspunkten und der Abkantung erzeugt werden. Auf die Kontaktgabe wirkt es sich in diesem Zusammenhang günstig aus, wenn die Abkantung unter einem geringen stumpfen Winkel zu der Ebene der Abdeckung stehend ausgebildet ist. Hierdurch ist ein spitzwinkliges Zusammentreffen zwischen den Zähnen oder der sonstwie ausgebildeten Kontaktleiste und der einen Flanke der Einziehung der Profilschiene zu erreichen.

Durch die EP-A-0 404 284 ist es bereits bekanntgeworden, ausgehend von der einen Flanke der Einziehung und der an schließenden Teilfläche der Profilschiene eine Schrägfläche vorzusehen. Eine solche Schrägfläche ist auch im vorliegenden Zusammenhang vorteilhaft anwendbar, und zwar in solcher Ausführung, daß die Schrägfläche unter einem von 45° bezüglich der Ebene der Teilfläche wesentlich abweichenden Winkel angeordnet ist. Diese Maßnahme fördert die Unterdrückung einer störenden Strahlung durch mehrfache Reflektion. Zugleich wird die Möglichkeit geschaffen, ein Dichtungselement zwischen der Abdeckung und der Profilschiene einzulegen, falls ein besonders hohes Maß an Dichtigkeit gegen Staub und Wasser gefordert wird.

Für die Aufrechterhaltung der erwünschten Dämpfung für elektromagnetische Strahlung ist es wesentlich, daß die gewählten Abstände dauerhaft aufrechterhalten bleiben. Dies ist nach einer weiteren Ausgestaltung der Erfindung dadurch zu erreichen, daß die von der Einziehung weiter entfernte Teilfläche der Profilschiene gegenüber der an die Einziehung anschließenden Teilfläche um ein solchen Maß zurückgsetzt angeordnet ist, daß bei Einhaltung des vorgesehenen Abstandes zwischen der Abdeckung und der an die Einziehung anschließender Teilfläche die Höhe der Einprägungen zur Aufnahme der Köpfe von Befestigungsschrauben ausreicht. Der Angriff der Befestigungskräfte an den den gewünschten Abstand bestimmenden Einprägungen gewährleistet eine dauerhafte Aufrechterhaltung dieses Abstandes.

Wie bereits erwähnt, steht die Abdeckung in einem geringen Abstand der einen Teilfläche der Profilschiene gegenüber. Die Länge dieser Teilfläche kann vorzugsweise etwa dem Zwanzigfachen des geringen Abstandes entsprechen.

Die Erfindung wird im folgenden anhand der in den Figuren dargestellten Ausführungsbeispiele näher erläutert.

Die Figur 1 zeigt einen Schaltschrank in schematischer Darstellung in einer Frontansicht.

In der Figur 2 sind eine Profilschiene und eine an dieser anzubringende Abdeckung im Schnitt und in vergrößertem Maßstab dargestellt.

Die Figuren 3 und 4 zeigen Einzelheiten im Bereich einer Profilschiene und einer mit dieser zusammenwirkenden Abdeckung im Querschnitt und in einer geschnittenen Frontansicht.

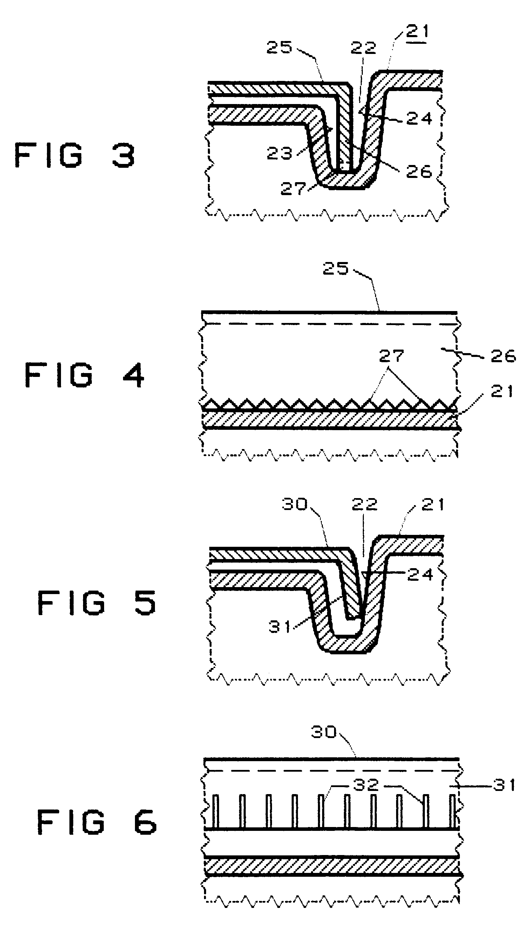

Eine weitere Ausführungsform, bei der eine stumpfwinklige Abkantung vorgesehen ist, zeigen die Figuren 5 und 6 in einer den Figuren 3 und 4 entsprechenden Darstellung.

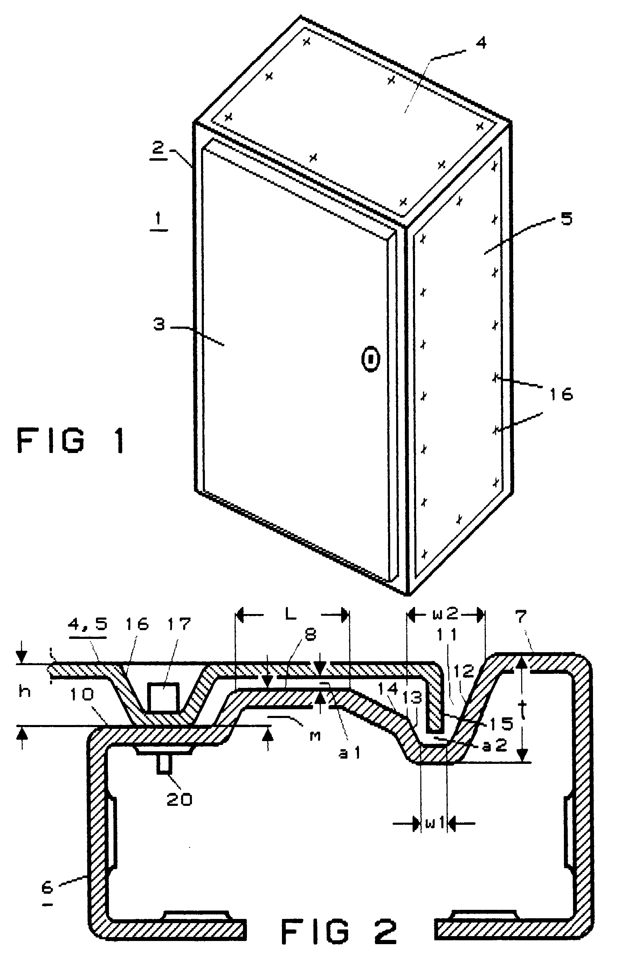

Der in der Figur 1 gezeigte Schaltschrank 1 weist ein Gerüst 2 auf, das beispielsweise so aufgebaut sein kann, wie dies in der EP-A-0 404 284 beschrieben ist. Das Gerüst 2 ist frontseitig mit einer Tür 3 und an den übrigen Seiten mit Abdeckungen versehen, von denen eine obere Abdeckung 4 und eine seitliche Abdeckung 5 sichtbar sind. Anhand der Figur 2 wird im folgenden näher beschrieben, wie die Abdeckungen 4 bzw. 5 an dem Gerüst 2 befestigt sind und wie eine gewünschte starke Dämpfung des Durchtrittes elektromagnetischer Strahlung in das Innere des Schaltschrankes 1 erzielt wird.

Die Figur 2 zeigt die Querschnittsform eines Profilelementes 6, aus denen das Gerüst 2 (Figur 1) zusammengesetzt ist. Ein Randbereich der Abdeckung 4 ist auf der Profilschiene 6 aufliegend gleichfalls geschnitten gezeigt. Wie die Figur 2 erkennen läßt, weist die Profilschiene 6 eine mehrfach abgewinkelte Form auf und bildet insgesamt ein offenes Hohlprofil, wobei die offene Seite zum Innenraum des Schaltschrankes weist. An seiner mit der Abeckung 4 zusammenwirkenden Seite besitzt die Profilschiene 6 drei Teilflächen 7, 8 und 10, die derart gegeneinander versetzt angeordnet sind, daß die Teilfläche 7 die am weitesten außenliegende Fläche darstellt, der gegenüber die mittlere Teilfläche 8 zurückgesetzt ist. Die Teilfläche 10 ist ihrerseits gegenüber der Teilfläche 8 zurückgesetzt. Zwischen der Teilfläche 7 und den beiden weiteren Teilflächen 8 und 10 befindet sich eine Einziehung 11, deren Flanken 12 und 13 gegenüber einer zu den Teilflächen rechtwinklig stehenden Linie einen Winkel von etwa 10 bis 15° einschließen. Dieser Winkel ist so gewählt, daß die in der Figur 2 gezeigte Mündungsweite w2 der Einziehung 11 zu der Fußweite w1 etwa im Verhältnis 2:1 steht. Geeignete Abmessungen sind w1 = 5 bis 6 mm und w2 = 10 bis 14 mm bei einer Materialdicke der Abdeckungen von etwa 1,5 mm und einer Materialdicke der Profilschiene von etwa 2 mm. Die Einziehung bildet daher über die Länge der Profilschiene 6 eine keilförmige Nut. Am Übergang zwischen der Flanke 13 und der Teilfläche 8 ist ein Knick vorgesehen, durch den eine Schrägfläche 14 gebildet wird, deren Winkel zur Ebene der Teilfläche 8 etwa 30° beträgt, d. h. erheblich kleiner als 45° bemessen ist.

Die Abdeckung 4 besitzt an ihrem Ende eine Abkantung 15, die in die Einziehung 11 hineinragend angeordnet ist. Ferner ist die Abdeckung 4 in gewissen Abständen mit Einprägungen 16 versehen, mit denen die Abdeckung 4 auf der Teilfläche 10 aufliegt. In der Figur 1 sind die Einprägungen 16 durch Mittelkreuze angedeutet. Die Höhe h der Einprägungen 16 ist einerseits so bemessen, daß die Köpfe 17 von Befestigungsschrauben 20 vollständig in den durch die Einprägungen gebildeten Vertiefungen Platz finden und somit nicht über die Ebene der Abdeckung überstehen. Ferner ist die Tiefe der Einprägungen in Verbindung mit dem Versatz m der Teilflächen 8 und 10 gegeneinander so bemessen, daß sich im Bereich der Teilfläche 8 der Profilschiene 6 ein Abstand a1 bildet, der kleiner als die Dicke des Blechmaterials der Abdeckung 4 ist und etwa 1 mm beträgt. Der Abstand a1 besteht somit über die Länge L der Teilfläche 8, die etwa 20 mm und damit etwa das 20-fache des Abstandes a1 beträgt. Ferner sind die Länge der Abkantung 15 und die Tiefe der Einziehung 11 so bemessen, daß sich zwischen dem Boden der Einziehung 11 und dem Ende der Abkantung 15 ein Abstand a2 von etwa 2 mm ergibt.

Wie die Figur 2 zeigt, besteht aufgrund der Abstände a1 und a2 am gesamten Umfang der Abdeckung 4 eine Verbindung zwischen der Umgebung des Schaltschrankes 1 (Figur 1) und seinem Innenraum. Dadurch besteht die Möglichkeit des Druckausgleiches und des Luftaustausches. Die beschriebene Formgebung und Bemessung der Teile bewirkt jedoch, daß in beliebiger Richtung auftreffende elektromagnetische Strahlung nur in derart geschwächter Form den Innenraum des Schaltschrankes 1 erreicht, daß ein störender Einfluß nicht festzustellen ist.

Die in der Figur 2 im Bereich der Einziehung 11 gezeigte Schrägfläche 14 kann dazu benutzt werden, entsprechend der EP-A-0 404 284, einen elastischen Dichtungsstreifen anzuordnen, wenn eine vollkommene Dichtigkeit des Schaltschrankes erwünscht ist. Das zu verwendende Dichtungsmaterial braucht jedoch nur im Hinblick auf eine mechanische Abdichtung ausgewählt zu werden, weil die Dämpfung der elektromagnetischen Wellen unabhängig von einer solchen Dichtung durch die Formgebung und Bemessung der Teile gewährleistet ist. Die Schrägfläche 14 beginnt bei etwa der halben Tiefe der Einziehung 11 und steht unter einem Winkel von etwa 30° zu der Ebene der Abdeckung 4 bzw. 5. In dem durch die Schrägfläche 14 geschaffenen erweiterten Raum zwischen der Abdeckung und der Profilschiene werden eingedrungene elektromagnetische Wellen mehrfach reflektiert und dadurch geschwächt.

In den Figuren 3 und 4 ist als Ausschnitt nur derjenige Bereich dargestellt, in dem eine Abdeckung 25 in eine Einziehung 22 einer Profilschiene 21 eingreift. Die Abdeckung 25 unterscheidet sich von der Abdeckung 4 bzw. 5 durch die Ausbildung ihrer Abkantung 26 als Kontaktleiste. Ferner unterscheidet sich die Profilschiene 21 von der zuvor beschriebenen Profilschiene 6 durch das Fehlen einer Schrägfläche im Bereich der einen Flanke 23 der Einziehung 22. Jedoch könnte auch eine Profilschiene mit der erwähnten Schrägfläche benutzt werden.

Zur Bildung der Kontaktleiste ist an der Unterkante der Abkantung 26 eine Reihe von Zähnen 27 vorgesehen, die auf dem Boden der Einziehung 22 aufliegen. Die Zähne durchstoßen mit ihren Schneiden eine am Boden der Einziehung 22 befindliche Farb-, Kunststoff- oder sonstige Schicht und ermöglichen hierdurch eine gute elektrische Verbindung zwischen der Abdeckung 25 und der Profilschiene 21. Eine gewisse Durchlässigkeit ist an dieser Stelle dennoch gegeben, da zwischen den Zähnen Luft hindurchtreten kann. Eine für die Kontaktgabe erwünschte Andruckkraft kann zugleich mit der Befestigung aufgebracht werden. Dies kann z. B. dadurch geschehen, daß durch ein bewußt gewähltes Übermaß der Länge der Abkantung 26 einschließlich der Zähne 27 beim Anziehen sinngemäß wie in der Figur 2 angeordneter Schrauben eine gewisse Biegung des zwischen den Befestigungsschrauben und der Abkantung gelegenen Teiles der Abdeckung 25 hervorgerufen wird.

In dem weiteren Beispiel gemäß der Figur 5 ist in Verbindung mit einer der Figur 3 entsprechenden Profilschiene 21 eine Abdeckung 30 gezeigt, deren Abkantung 31 unter einem geringen stumpfen Winkel zu der Ebene der Abdeckung 30 steht. Dies bewirkt eine Berührung des Endes der Abkantung 31 mit der Flanke 24 der Einziehung 22. Ebenso wie in dem Beispiel gemäß den Figuren 3 und 4 ist die Abkantung als Kontaktleiste ausgebildet, wobei gleichfalls eine gezahnte Kante vorgesehen sein kann. Eine weitere Möglichkeit zur Bildung einer Kontaktleiste können Einschnitte zur Bildung federnder Finger sein. Solche Einschnitte 32 sind in der Figur 6 gezeigt, die im übrigen der Figur 4 entspricht.

Für alle beschriebenen Ausführungsformen gilt, daß sie wahlweise für eine, mehrere oder alle Abdeckungen eines Schaltschrankes anwendbar sind.

## Patentansprüche

1. Schaltschrank (1) zur wahlweisen Aufnahme elektrischer und/oder elektronischer Geräte und Baugruppen mit folgenden Merkmalen:
- ein Gerüst (2) aus Profilschienen (6) mit mehrfach abgewinkelter Querschnittsform:
- wenigstens eine Tür (3) und Abdeckungen (4, 5) zur Verkleidung des Gerüstes (2) und zum Schutz der Geräte und/oder Baugruppen gegen Einflüsse der Umgebung einschließlich der elektromagnetischen Wellen in einem die Funktion der Geräte und/oder Baugruppen betreffenden Frequenzbereich;
- die Profil schienen (6) besitzen an ihrer für das Zusammenwirken mit einer Abdeckung (4, 5) vorgesehenen Seite eine Einziehung (11) sowie drei gegeneinander versetzte Teilflächen (7, 8, 10), von denen die eine Teilfläche (7) durch die Einziehung (11) von den weiteren beiden Teilflächen (8, 10) getrennt ist;
- die Abdeckung (4, 5) besitzt an ihrem Rand eine Abwinklung (15) zum Eingreifen in die Einziehung (11) der Profilschiene (6);
- die Abdeckung (4, 5) überdeckt die weiteren beiden an die Einziehung (11) angrenzenden Teilflächen (8, 10) der Profilschiene (6);
**gekennzeichnet durch**
folgende Merkmale:
- die Abdeckung (4, 5) besitzt in einer Reihe angeordnete Einprägungen (16) zur Auflage auf der von der Einziehung (11) weiter entfernten Teilfläche (10) der Profilschiene (6);
- die Höhe (h) der Einprägungen (16) ist zur Erlangung eines geringen, die Dicke des Materials der Abdeckung (4, 5) nicht übersteigenden Abstandes (a1) zwischen der Abdeckung (4, 5) und der einen an die Einziehung (11) angrenzenden, von der Abdeckung (4, 5) überdeckten Teilfläche (8) der Profilschiene (6) bemessen;
die Einziehung (11) besitzt eine Fußweite (w1) von etwa der doppelten Dicke des Materials des Profilschiene (6).

2. Schaltschrank nach Anspruch 1,
**dadurch gekennzeichnet**, daß der geringe Abstand (a1) zwischen der an die Einziehung (11) angrenzenden Teilfläche (8) und der Abdeckung (4, 5) etwa der halben Dicke des Materials der Abdeckung (4, 5) entspricht.

3. Schaltschrank nach Anspruch 1,
**dadurch gekennzeichnet**, daß die Einziehung (11) eine Tiefe (t) von etwa dem zwei- bis dreifachen Wert der Fußweite (w1) und daß die die Einziehung eine Mündungsweite (w2) besitzt, die zu der Fußweite (w1) im Verhältnis von etwa zwei zu eins steht.

4. Schaltschrank nach Anspruch 3,
**dadurch gekennzeichnet**, daß das Ende der Abkantung (15) der Abdeckung (4, 5) dem Boden der Einziehung (11) in einem etwa der Dicke des Materials der Abdeckung (4, 5) entsprechenden Abstand (a2) gegenübersteht.

5. Schaltschrank nach Anspruch 3,
**dadurch gekennzeichnet**, daß die Abkantung (26) als Kontaktleiste zur leitenden Verbindung der Abdeckung (25) mit der Profilschiene (21) ausgebildet ist.

6. Schaltschrank nach Anspruch 5,
**dadurch gekennzeichnet**, daß die Kontaktleiste durch im Endbereich der Abkantung (26) angeordnete Zähne (27) gebildet ist.

7. Schaltschrank nach Anspruch 5 oder 6,
**dadurch gekennzeichnet**, daß die Abkantung (31) unter einem geringen stumpfen Winkel zu der Ebene der Abdeckung (30) stehend ausgebildet ist.

8. Schaltschrank nach einem der vorangehenden Ansprüche,
**dadurch gekennzeichnet**, daß ausgehend von der einen Flanke (13) der Einziehung (11) und der an die Einziehung anschließenden, von der Abdeckung (4 ,5) überdeckten Teilfläche (8) der Profilschiene (6) unter einem von 45° bezüglich der Ebene der Teilfläche (8) wesentlich abweichenden Winkel eine Schrägfläche (14) angeordnet ist.

9. Schaltschrank nach einem der vorangehenden Ansprüche,
**dadurch gekennzeichnet**, daß die von der Einziehung (11) weiter entfernte Teilfläche (10) der Profilschiene (6) gegenüber der an die Einziehung (11) anschließenden Teilfläche (8) um ein solches Maß (m) zurückgesetzt angeordnet ist, daß bei Einhaltung des vorgesehenen Abstandes (a1) zwischen der Abdeckung (4, 5) und der an die Einziehung (11) anschließenden Teilfläche (8) die Höhe (h) der Einprägungen (16) zur Aufnahme der Köpfe (17) von Befestigungsschrauben (20) ausreicht.

10. Schaltschrank nach einem der vorangehenden Ansprüche,
**dadurch gekennzeichnet**, daß die der Abdeckung (4, 5) in geringem Abstand (a1) gegenüberstehende Teilfläche (8) der Profilschiene (6) eine Länge (L) von etwa dem Zwanzigfachen des geringen Abstandes (a1) besitzt.

## Claims

1. A switch cabinet (1) for selectively housing electric and/or electronic devices and assemblages having the following features:
- a framework (2) made of profile rails (6) with a multi-angled cross sectional shape;
- at least one door (3) and covers (4, 5) for cladding the framework (2) and for protecting the devices and/or assemblages against environmental influences including electromagnetic waves in a frequency range affecting the operation of the devices and/or assemblages;
- on their side provided for cooperation with a cover (4, 5), the profile rails (6) comprise a recess (11) and three partial surface areas (7, 8, 10), which are offset relative to one another and of which one partial surface area (7) is separated by the recess (11) from the two further partial surface areas (8, 10);
- at its edge, the cover (4, 5) comprises an angled section (15) for engaging in the recess (11) of the profile rail (6);
- the cover (4, 5) covers the two further partial surface areas (8, 10) of the profile rail (6) adjoining the recess (11);
characterised by the following features:
- the cover (4, 5) comprises indentations (16) arranged in a row for placing over the partial surface area (10) of the profile rail (6) furthest from the recess (11);
- the height (h) of the indentations (16) is measured so as to produce a short distance (a1) between the cover (4, 5) and the partial surface area (8) of the profile rail (6) adjoining the recess (11) and covered by the cover (4, 5), which distance does not exceed the thickness of the material of the cover (4, 5);
- the recess (11) has a base width (w1) approximately twice the thickness of the material of the profile rail (6).

2. A switch cabinet according to claim 1, characterised in that the short distance (a1) between the partial surface area (8) adjoining the recess (11) and the cover (4, 5) corresponds approximately to half the thickness of the material of the cover (4, 5).

3. A switch cabinet according to claim 1, characterised in that the recess (11) has a depth (t) approximately two to three times the value of the base width (w1) and the recess has a mouth width (w2) having a ratio to the base width (w1) of approximately 2 : 1.

4. A switch cabinet according to claim 3, characterised in that the end of the angled section (15) of the cover (4, 5) is arranged opposite the base of the recess (11) at a distance (a2) corresponding approximately to the thickness of the material of the cover (4, 5).

5. A switch cabinet according to claim 3, characterised in that the angled section (15) is constructed as a contact strip for the conductive connection of the cover (25) and the profile rail (21).

6. A switch cabinet according to claim 5, characterised in that the contact strip is formed by teeth (27) arranged in the end region of the angled section (26).

7. A switch cabinet according to claim 5 or 6, characterised in that the angled section (31) is constructed to form a slightly obtuse angle with the plane of the cover (30).

8. A switch cabinet according to one of the preceding claims, characterised in that an inclined surface (14), which extends from one flank (13) of the recess (11) to the partial surface area (8) of the profile rail (6) adjoining the recess and covered by the cover (4, 5), is arranged at an angle relative to the plane of the partial surface area (8) substantially deviating from 45°.

9. A switch cabinet according to one of the preceding claims, characterised in that the partial surface area (10) of the profile rail (6) furthest from the recess (11) is arranged set back from the adjoining partial surface area (8) by such a distance (m) that, whilst maintaining the provided distance (a1) between the cover (4, 5) and the partial surface area (8) adjoining the recess (11), the height (h) of the indentations (16) is sufficient for accommodating the heads (17) of securing screws (20).

10. A switch cabinet according to one of the preceding claims, characterised in that the partial surface area (8) of the profile rail (6) arranged at a short distance (a1) opposite the cover (4, 5) has a length (L) approximately twenty times the short distance (a1).

## Revendications

1. Armoire de commande (1) destinée à recevoir au choix des appareils électriques et des modules électriques et/ou électroniques, présentant les caractéristiques suivantes :
- une ossature (2) formée de rails profilés (6) possédant une forme en coupe transversale repliée de façon multiple;
- au moins une porte (3) et des éléments de revêtement (4, 5) servant à habiller l'ossature (2) et à protéger les appareils et/ou les modules vis-à-vis d'influences de l'environnement, y compris vis-à-vis des ondes électromagnétiques dans une gamme de fréquences concernant le fonctionnement des appareils et/ou des modules;
- les rails profilés (6) possèdent, sur leur côté destiné à coopérer avec un élément de revêtement (4.5), un renfoncement (11) ainsi que trois surfaces partielles (7, 8, 10), qui sont décalées réciproquement et dont l'une (7) est séparée des deux autres surfaces partielles (8, 10), par le renfoncement (11);
- l'élément de revêtement (4,5) possède sur son bord une partie coudée (15) destinée à s'engager dans le renfoncement (15) du rail profilé (6);
- l'élément de revêtement (4,5) recouvre les deux autres surfaces partielles (8,10) du rail profilé (6), qui sont contiguës au renfoncement (11),
caractérisée par les caractéristiques suivantes :
- l'élément de revêtement (4,5) possède des parties gaufrées en creux (16) disposées en série et destinées à s'appliquer sur la surface partielle (10) du rail profilé (6), qui est la plus éloignée du renfoncement (11);
- la hauteur (h) des parties gaufrées en creux (16) est dimensionnée de manière à obtenir une faible distance (a1), qui ne dépasse pas l'épaisseur du matériau de l'élément de revêtement (4, 5), entre cet élément de revêtement (4,5) et une surface partielle (8) du rail profilé (6), qui est contiguë au renfoncement (11) et est recouverte par l'élément de revêtement (4,5);
- le renfoncement (11) possède une largeur (w) à sa base, qui est égale approximativement au double de l'épaisseur du matériau du rail profilé (6).

2. Armoire de commande suivant la revendication 1, caractérisée par le fait que la faible distance (a) entre la surface partielle (8), qui est contiguë au renfoncement (11), et l'élément de revêtement (4,5) est égale approximativement à la moitié de l'épaisseur du matériau de l'élément de revêtement (4,5).

3. Armoire de commande suivant la revendication 1, caractérisée par le fait que le renfoncement (11) possède une profondeur (a) comprise approximativement entre deux et trois fois la valeur de la largeur (w1) de la base, et que le renfoncement possède une largeur d'embouchure (w2), qui se situe dans un rapport compris entre environ deux et un par rapport à la largeur (w1) de la base.

4. Armoire de commande suivant la revendication 3, caractérisée par le fait que l'extrémité du bord replié (15) de l'élément de revêtement (4,5) est en vis-à-vis du fond du renfoncement (11) en en étant séparée par une distance (a2) correspondant approximativement à l'épaisseur du matériau de l'élément de revêtement (4,5).

5. Armoire de commande suivant la revendication 3, caractérisée par le fait que le bord replié (26) est réalisé sous la forme d'une barrette de contact pour l'établissement d'une liaison conductrice entre l'élément de revêtement (25) et le rail profilé (21).

6. Armoire de commande suivant la revendication 5, caractérisée par le fait que la barrette de contact est formée par des dents (27) disposées dans la zone d'extrémité du bord replié (26).

7. Armoire de commande suivant la revendication 5 ou 6, caractérisée par le fait que le bord replié (31) est réalisé de manière à faire un angle faible obtus par rapport au plan de l'élément de revêtement (30).

8. Armoire de commande suivant l'une des revendications précédentes, caractérisé par le fait qu'une surface oblique (14) s'étend à partir d'un flanc (13) du renfoncement (11) et de la surface partielle (8) du rail profilé (6), qui est contigu au renfoncement et est recouvert par l'élément de revêtement (4, 5), en faisant un angle par rapport au plan de la surface partielle (8), qui diffère nettement de 45°.

9. Armoire de commande suivant l'une des revendications précédentes, caractérisée par le fait que la surface partielle (10), qui est la plus éloignée du renfoncement (11), du rail profilé (6) est disposée en retrait, par rapport à la surface partielle (8) contiguë au renfoncement (11), d'une distance (m) telle que, dans le cas où la distance prévue (a1) entre l'élément de revêtement (4,5) et la surface partielle (8) contiguë au renfoncement (11) est respectée, la hauteur (h) des parties gaufrées en creux (16) est suffisante pour loger les têtes (17) de vis de fixation (20).

10. Armoire de commande suivant l'une des revendications précédentes, caractérisée par le fait que la surface partielle (8) du rail profilé (6), qui est située en vis-à-vis et à une faible distance (a1) de l'élément de revêtement (4, 5), possède une longueur (L) égale approximativement à vingt fois la faible distance (a1).
